# EUROPÄISCHE PATENTSCHRIFT

(11) **EP 2 606 515 B1**
(45) Veröffentlichungstag und Bekanntmachung des Hinweises auf die Patenterteilung: **01.01.2020**
(21) Anmeldenummer: 11748330.5
(22) Anmeldetag: 04.08.2011
(51) Int. Cl.: H01L 33/56, H01L 33/44, H01L 25/075, G02B 5/02

(54) **Leuchtdiode**
Light emitting diode
Diode électroluminescente

(30) Priorität: 20.08.2010 DE 102010034915
(43) Veröffentlichungstag der Anmeldung: 26.06.2013
(73) Patentinhaber: OSRAM Opto Semiconductors GmbH, 93055 Regensburg (DE)
(72) Erfinder: WIRTH, Ralph, 93138 Lappersdorf (DE)
(74) Vertreter: Zacco Patent- & Rechtsanwälte
(86) Internationale Anmeldenummer: PCT/EP2011/063483
(87) Internationale Veröffentlichungsnummer: WO 2012/022628

(56) Entgegenhaltungen:
- DE-A1-102005 013 785
- US-A1- 2004 198 924
- US-A1- 2006 060 882
- US-A1- 2009 243 457
- US-A1- 2010 025 709
- WATANABE TOSHIO ET AL: "Influence of humidity on refractive index of polymers for optical waveguide and its temperature dependence", APPLIED PHYSICS LETTERS, AIP, AMERICAN INSTITUTE OF PHYSICS, MELVILLE, NY, US, Bd. 72, Nr. 13, 30. März 1998 (1998-03-30) , Seiten 1533-1535, XP012019882, ISSN: 0003-6951, DOI: 10.1063/1.120574
- J. H. WRAY ET AL: "Refractive Index of Several Glasses as a Function of Wavelength and Temperature", JOURNAL OF THE OPTICAL SOCIETY OF AMERICA, Bd. 59, Nr. 6, 1. Juni 1969 (1969-06-01), Seite 774, XP55010306, ISSN: 0030-3941, DOI: 10.1364/JOSA.59.000774
- SAMEER CHHAJED: "Junction temperature in light-emitting diodes assessed by different methods", PROCEEDINGS OF SPIE, Bd. 5739, 1. Januar 2005 (2005-01-01), Seiten 16-24, XP55010311, ISSN: 0277-786X, DOI: 10.1117/12.593696

## Beschreibung

Es wird eine Leuchtdiode angegeben.

Herkömmliche optoelektronische Halbleiterbauteile, insbesondere Leuchtdioden, mit Streukörpern sind aus den Dokumenten US 2010/025709 A1, US 2006/060882 A1 und DE 10 2005 013 785 A1 bekannt.

Eine zu lösende Aufgabe besteht darin, eine Leuchtdiode anzugeben, die eine näherungsweise stabile spektrale Abstrahlcharakteristik aufzeigt.

Die vorliegende Erfindung offenbart eine Leuchtdiode gemäß Patentanspruch 1. Besondere Ausführungsformen der Erfindung sind in den abhängigen Patentansprüchen angegeben.

Gemäß zumindest einer Ausführungsform der Leuchtdiode, kurz LED, umfasst diese einen oder mehrere optoelektronische Halbleiterchips. Bei den Halbleiterchips handelt es sich insbesondere um auf einem III-V-Halbleitermaterial basierende Halbleiterchips. Beispielsweise basieren die Halbleiterchips auf einem Nitrid-Verbindungshalbleitermaterial wie AlₙIn₁₋ₙGaₘN oder auf AlₙIn₁₋ₙGaₘP, wobei jeweils 0 ≤ n ≤ 1, 0 ≤ m ≤ 1 und n+m ≤ 1. Dabei kann dieses Material einen oder mehrere Dotierstoffe sowie zusätzliche Bestandteile aufweisen. Der Einfachheit halber sind jedoch nur die wesentlichen Bestandteile des Kristallgitters, also Al, Ga, In, N oder P, angegeben, auch wenn diese teilweise durch geringe Mengen weiterer Stoffe ersetzt und/oder ergänzt sein können. Bevorzugt sind die optoelektronischen Halbleiterchips dazu eingerichtet, im Betrieb der Leuchtdiode eine sichtbare Strahlung, beispielsweise im blauen, im grünen, im gelben und/oder im roten Spektralbereich, zu erzeugen. Die Strahlungserzeugung erfolgt bevorzugt in mindestens einer aktiven Zone, die mindestens eine Quantentopfstruktur und/oder mindestens einen pn-Übergang beinhaltet.

Es können alle Halbleiterchips der Leuchtdiode baugleich sein. Alternativ ist es möglich, dass die Leuchtdiode verschiedenartige, insbesondere auf verschiedenen Halbleitermaterialien basierende Halbleiterchips beinhaltet, die bevorzugt zur Emission in verschiedenen Spektralbereichen eingerichtet sind.

Die Leuchtdiode emittiert inkohärente Strahlung.

Gemäß zumindest einer Ausführungsform der Leuchtdiode umfasst diese mindestens einen Streukörper. Der Streukörper weist ein für Strahlung durchlässiges, bevorzugt ein klarsichtiges und transparentes Matrixmaterial auf, in das Streupartikel eingebettet sind. Die Streupartikel bestehen aus einem Partikelmaterial. Das Partikelmaterial ist von dem Matrixmaterial verschieden.

Gemäß zumindest einer Ausführungsform des Streukörpers ist dieser nicht oder näherungsweise nicht zu einer Änderung eines Spektrums der von dem Halbleiterchip emittierten Strahlung eingerichtet. Insbesondere ist der Streukörper frei von einem Filtermittel und/oder frei von einem Konversionsmittel, das zu einer teilweisen oder vollständigen Wellenlängenkonversion der von dem Halbleiterchip emittierten Strahlung eingerichtet ist. Es ist der Streukörper also dann ausschließlich oder im Wesentlichen zu einer Streuung und/oder Reflexion und nicht zu einer Absorption oder spektralen Umwandlung der von dem Halbleiterchip emittierten Strahlung eingerichtet.

Gemäß zumindest einer Ausführungsform der Leuchtdiode ist der Streukörper wenigstens einem der Halbleiterchips nachgeordnet. Weist die Leuchtdiode mehrere baugleiche Halbleiterchips auf, so ist ein gemeinsamer Streukörper den Halbleiterchips nachgeordnet oder es ist insbesondere jedem der Halbleiterchips ein eigener Streukörper nachgeordnet. Weist die Leuchtdiode voneinander verschiedene, nicht baugleiche Halbleiterchips auf, so ist es möglich, dass nur einem Teil der Halbleiterchips ein Streukörper nachgeordnet ist. Nachgeordnet bedeutet insbesondere, dass entlang einer Hauptabstrahlrichtung den Halbleiterchips der Streukörper nachfolgt. Der Streukörper kann unmittelbar an oder auf dem Halbleiterchip angebracht sein.

Gemäß zumindest einer Ausführungsform der Leuchtdiode verändert sich ein Brechungsindexunterschied zwischen dem Matrixmaterial und dem Partikelmaterial bei einer Temperaturänderung. Mit anderen Worten ist ein temperaturabhängiger Verlauf des Brechungsindexes des Matrixmaterials von einem temperaturabhängigen Verlauf des Brechungsindexes des Partikelmaterials verschieden.

Beispielsweise kann der Brechungsindex gegenüber der Temperatur im relevanten Temperaturbereich sowohl für das Matrixmaterial als auch für das Partikelmaterial näherungsweise durch eine Gerade beschreibbar sein. Die Geraden, die den temperaturabhängigen Brechungsindex des Matrixmaterials und des Partikelmaterials beschreiben, können dann voneinander verschiedene Steigungen aufweisen. Die Steigungen können gleiche oder auch unterschiedliche Vorzeichen aufweisen.

Gemäß zumindest einer Ausführungsform der Leuchtdiode beträgt der Brechungsindexunterschied zwischen dem Matrixmaterial und dem Partikelmaterial bei einer Temperatur von 300 K höchstens 0,15, bevorzugt höchstens 0,10, insbesondere höchstens 0,07 oder höchstens 0,05. Das heißt, bei Raumtemperatur ist der Brechungsindexunterschied zwischen dem Matrixmaterial und dem Partikelmaterial vergleichsweise klein. Jedoch unterscheiden sich die Brechungsindices bevorzugt voneinander, sodass der Brechungsindexunterschied ungleich Null ist.

In mindestens einer Ausführungsform der Leuchtdiode weist diese einen oder mehrere optoelektronische Halbleiterchips auf, die insbesondere zu einer Emission von sichtbarem Licht vorgesehen sind. Weiterhin umfasst die Leuchtdiode mindestens einen Streukörper, der ein strahlungsdurchlässiges, bevorzugt ein transparentes, Matrixmaterial und darin eingebettete Streupartikel aus einem Partikelmaterial beinhaltet. Der Streukörper ist wenigstens einem der Halbleiterchips, insbesondere entlang einer Hauptabstrahlrichtung des Halbleiterchips, diesem nachgeordnet. Bei einer Temperaturänderung verändert sich ein Brechungsindexunterschied zwischen dem Matrixmaterial und dem Partikelmaterial. Bei einer Temperatur von 300 K beträgt der Brechungsindexunterschied zwischen dem Matrixmaterial und dem Partikelmaterial höchstens 0,15.

Leuchtdioden werden bei unterschiedlichen Temperaturen betrieben. Beim Anschalten hat zum Beispiel eine aktive Zone des Halbleiterchips in etwa Umgebungstemperatur, beispielsweise Raumtemperatur. Während einer Aufwärmphase, deren Dauer insbesondere abhängig ist von thermischen Widerständen des Halbleiterchips sowie der Leuchtdiode und abhängig ist von einer Ankopplung an eine Wärmesenke, steigt eine Temperatur der aktiven Zone an, bis typischerweise eine stabile Temperatur in einem stationären Arbeitspunkt erreicht ist. Dieser Vorgang spielt sich im Regelfall in einem Zeitraum der ersten 10 min bis 30 min nach dem Einschalten ab. Nach der Aufwärmphase liegt die Temperatur beispielsweise zwischen circa 75° C und 125° C, wobei in dem stationären Arbeitspunkt die Temperatur auch bei über 150° C liegen kann.

Bei für optoelektronische Halbleiterchips verwendeten Materialsystemen ändert sich ein Lichtstrom oder ein Strahlungsfluss typischerweise in Abhängigkeit von der Temperatur, insbesondere bei Vorliegen eines konstanten, temperaturunabhängigen Stroms. Höhere Arbeitstemperaturen führen in der Regel zu einem Abnehmen des Lichtstroms. Beispielsweise für auf InGaN basierende Halbleiterchips beträgt der Lichtstrom bei 100° C circa 85 % des Lichtstroms bei 25° C. Bei auf InGaAlP basierenden Halbleiterchips ist dieser Effekt stärker ausgeprägt, insbesondere auch, da sich die Emissionswellenlänge aus einem Bereich höherer Augenempfindlichkeit herausschiebt. So kann bei einem auf InGaAlP basierenden, im gelben Spektralbereich emittierenden Halbleiterchip die Helligkeit bei 100° C auf circa 40 % des Werts bei 25° C abfallen, bei einer Emission im roten Wellenlängenbereich kann dieser Abfall etwa 50 %, bezogen auf die vom menschlichen Auge empfundene Helligkeit, betragen.

Diese Temperaturabhängigkeit des Lichtstromes kann in Anwendungen Probleme verursachen. Beispielsweise bei Blinklichtern oder Rücklichtern im Automobilbereich ist ein bestimmter, vorgegebener Lichtstrom zu erreichen. Sind die verwendeten Leuchtdioden kalt, nahe Raumtemperatur, so leuchten diese zu hell. Bei der Allgemeinbeleuchtung von Arbeitsräumen oder von Wohnräumen werden insbesondere grünlich-weiß emittierende Halbleiterchips mit roten Halbleiterchips oder rote, grüne, blaue und/oder gelbe Halbleiterchips miteinander kombiniert. Bei einer derartigen Kombination von verschiedenartig emittierenden Halbleiterchips und dem mit steigender Temperatur einhergehenden, vergleichsweise starken Abfall des Lichtstromes der roten und gegebenenfalls gelben LEDs kann es zu starken Farbveränderungen kommen. Beispielsweise ändert sich die korrelierte Farbtemperatur um 600 K von circa 2400 K bei Raumtemperatur hin zu 3000 K am stationären Arbeitspunkt des Halbleiterchips bei circa 100° C. Es wird also nach dem Einschalten rotstichiges Licht emittiert, bevor erst nach circa 10 min bis 30 min die gewünschte Lichtfarbe erreicht ist. Weiterhin können derartige, temperaturabhängige und sich über vergleichsweise lange Zeiträume erstreckende Farbänderungen bei Hinterleuchtungen etwa für Flüssigkristallanzeigen Probleme bereiten.

Eine derartige Helligkeitsänderung oder Änderung der spektralen Zusammensetzung der emittierenden Strahlung kann reduziert oder vermieden werden, indem so genannte Vollkonversionsleuchtdioden eingesetzt werden. Bei diesen Leuchtdioden, die insbesondere auf dem InGaN-Materialsystem beruhen, wird eine im Halbleiterchip emittierte Strahlung vollständig durch ein Konversionsmaterial in eine Strahlung anderer Wellenlänge umgewandelt. Derartige Leuchtdioden sind aber vergleichsweise teuer. Weiterhin ist es möglich, die Helligkeit und/oder die spektrale Zusammensetzung elektronisch nachzuregeln, beispielsweise in Verbindung mit Temperatursensoren und/oder optischen Sensoren und nachfolgender elektronischer Ansteuerung, beispielsweise über Pulsweitenmodulation. Jedoch sind diese Verfahren zur Nachregelung vergleichsweise aufwändig und kompliziert sowie relativ kostenintensiv.

Bei der angegebenen Leuchtdiode wird alternativ oder zusätzlich das Temperaturverhalten des Lichtstromes durch den Streukörper beeinflusst. Durch das unterschiedliche Temperaturverhalten der Brechungsindices von Matrixmaterial und Partikelmaterial ändert sich der Brechungsindexunterschied bei Raumtemperatur im Vergleich zum Brechungsindexunterschied beim stationären Arbeitspunkt, der zum Beispiel bei circa 100° C liegt. Durch eine Änderung des Brechungsindexunterschieds ändern sich die Licht streuenden Eigenschaften des Streukörpers. Hierdurch ist es möglich, dass der Streukörper bei Raumtemperatur stärker streut und bei höheren Temperaturen das Streuverhalten abnimmt. Mit anderen Worten ist über den Streukörper eine Abnahme des Lichtstromes aufgrund der temperaturabhängigen Effizienz des Halbleiterchips ausgleichbar. Hierdurch kann das System aus Streukörper und Halbleiterchip eine bei Temperaturänderung vergleichsweise konstante Lichtabstrahlung erzielen.

Gemäß zumindest einer Ausführungsform der Leuchtdiode ist der Brechungsindex des Partikelmaterials bei einer Temperatur von 300 K kleiner als der Brechungsindex des Matrixmaterials.

Gemäß zumindest einer Ausführungsform der Leuchtdiode nimmt der Brechungsindex des Matrixmaterials mit steigender Temperatur ab. Dies gilt insbesondere für einen Temperaturbereich zwischen einschließlich 300 K und 450 K. Alternativ oder zusätzlich steigt der Brechungsindex des Partikelmaterials mit steigender Temperatur in diesem Temperaturbereich an.

Gemäß zumindest einer Ausführungsform der Leuchtdiode nimmt der Brechungsindexunterschied zwischen dem Matrixmaterial und dem Partikelmaterial mit steigender Temperatur ab. Insbesondere gilt dies in einem Temperaturbereich zwischen einschließlich 300 K und 375 K und/oder zwischen einschließlich 375 K und 450 K.

Gemäß zumindest einer Ausführungsform der Leuchtdiode nimmt ein Brechungsindexunterschied zwischen dem Matrixmaterial und dem Partikelmaterial zumindest in einem Temperaturbereich zwischen einschließlich 300 K und 375 K und/oder zwischen einschließlich 375 K und 450 K zu.

Gemäß zumindest einer Ausführungsform der Leuchtdiode gleichen sich die Brechungsindices von Matrixmaterial und Partikelmaterial in einen Temperaturbereich zwischen einschließlich 300 K und 450 K mit zunehmender Temperatur zuerst an und nachfolgend, bei noch höheren Temperaturen in oder außerhalb des genannten Temperaturbereichs, nimmt ein Brechungsindexunterschied zwischen dem Matrixmaterial und dem Partikelmaterial wieder zu.

Gemäß zumindest einer Ausführungsform der Leuchtdiode beträgt ein mittlerer Streuquerschnitt der Streupartikel im Temperaturbereich zwischen einschließlich 375 K und 450 K höchstens 25 % des mittleren Streuquerschnitts der Streupartikel bei einer Temperatur von 300 K. Der mittlere Streuquerschnitt ist unter anderem abhängig von dem Brechungsindexunterschied zwischen dem Partikelmaterial und dem Matrixmaterial. Weiterhin gehen in den Streuquerschnitt geometrische Eigenschaften der Streupartikel, insbesondere die Form der Streupartikel und deren Größe, ein.

Mit anderen Worten nähern sich gemäß dieser Ausführungsform die Brechungsindices des Matrixmaterials und des Partikelmaterials soweit an, dass der Streuquerschnitt im Bereich der stationären Arbeitstemperatur des Halbleiterchips, also beispielsweise bei einer Temperatur zwischen einschließlich 375 K und 450 K, im Vergleich zum Streuquerschnitt der Streupartikel bei Raumtemperatur gering ist oder vernachlässigbar ist. Es wirken die Streupartikel bei Raumtemperatur also streuend, wohingegen bei der höheren stationären Arbeitstemperatur des Halbleiterchips die Streupartikel nicht oder nicht signifikant streuend wirken, aufgrund der Änderungen der Brechungsindices des Matrixmaterials und gegebenenfalls des Partikelmaterials.

Gemäß zumindest einer Ausführungsform der Leuchtdiode beträgt der Brechungsindexunterschied zwischen dem Matrixmaterial und dem Partikelmaterial bei einer Temperatur von 300 K mindestens 0,02 oder mindestens 0,025 oder mindestens 0,03.

Gemäß zumindest einer Ausführungsform der Leuchtdiode beträgt bei der stationären Arbeitstemperatur der Brechungsindexunterschied zwischen dem Matrixmaterial und dem Partikelmaterial höchstens 0,015, bevorzugt höchstens 0,010 oder höchstens 0,005. Insbesondere ist der Brechungsindexunterschied bei einer Temperatur von circa 400 K, oder bei einer davon abweichenden stationären Arbeitstemperatur des Halbleiterchips, vernachlässigbar oder gleich Null.

Gemäß zumindest einer Ausführungsform der Leuchtdiode beinhaltet das Matrixmaterial ein phenylisiertes Silikon. Gemäß zumindest einer Ausführungsform der Leuchtdiode ist das Partikelmaterial in einem Temperaturbereich von einschließlich 300 K bis 450 K transparent und klarsichtig. Zum Beispiel ist das Partikelmaterial eines der folgenden Materialien: Kalziumfluorid, Bariumfluorid, Lithiumfluorid oder Magnesiumfluorid.

Gemäß zumindest einer Ausführungsform der Leuchtdiode liegt ein mittlerer Durchmesser der Streupartikel bei mindestens 1,5 µm. Zusätzlich beträgt der mittlere Durchmesser höchstens 5 µm. Der mittlere Durchmesser ist hierbei insbesondere der Durchmesser d₅₀ über Q₀.

Gemäß zumindest einer Ausführungsform der Leuchtdiode beträgt ein Gewichtsanteil der Streupartikel an dem gesamten Streukörper zwischen einschließlich 10 % und 50 %, insbesondere zwischen einschließlich 20 % und 40 % oder zwischen einschließlich 25 % und 35 % oder zwischen einschließlich 15 % und 30 %. Alternativ oder zusätzlich liegt ein Volumenanteil der Streupartikel unterhalb von 30 % oder unterhalb von 25 % oder unterhalb von 20 %.

Gemäß zumindest einer Ausführungsform der Leuchtdiode ist der Streukörper plättchenartig oder scheibenartig geformt. Beispielsweise erstreckt sich der Streukörper dann über eine Strahlungshauptfläche des Halbleiterchips mit konstanter oder im Wesentlichen konstanter Dicke, wobei Flanken des Halbleiterchips ebenfalls von dem Streukörper bedeckt sein können. Eine Dicke der Schicht oder des Plättchens beträgt bevorzugt höchstens 500 µm oder höchstens 100 µm.

Gemäß zumindest einer Ausführungsform der Leuchtdiode ist der Streukörper linsenartig geformt. Beispielsweise weist der Streukörper die Form einer Sammellinse auf. Der Streukörper kann also sphärisch oder ellipsoid ausgebildet sein.

Gemäß zumindest einer Ausführungsform der Leuchtdiode gleicht sich, ausgehend von einer Temperatur von 300 K, der Brechungsindex des Matrixmaterials an den Brechungsindex des Partikelmaterials an, mindestens bis zu einer Temperatur von 375 K. Mit anderen Worten ändert sich der Brechungsindex des Matrixmaterials stärker als der Brechungsindex des Partikelmaterials. Beispielsweise bleibt der Brechungsindex des Partikelmaterials näherungsweise konstant und es ändert sich näherungsweise nur der Brechungsindex des Matrixmaterials. Zum Beispiel liegt eine temperaturabhängige Brechungsindexänderung des Partikelmaterials um mindestens einen Faktor 10 oder um mindestens einen Faktor 50 unterhalb der Brechungsindexänderung des Matrixmaterials, bezogen auf denselben Temperaturbereich. Der relevante Temperaturbereich liegt hierbei insbesondere zwischen einschließlich 300 K und 375 K und/oder zwischen einschließlich 375 K und 450 K.

Gemäß zumindest einer Ausführungsform der Leuchtdiode ist deren Lichtstrom insbesondere zwischen einschließlich 300 K und 375 K und/oder zwischen einschließlich 375 K und 450 K konstant oder nahezu konstant. Zum Beispiel ändert sich der Lichtstrom in den angegebenen Temperaturbereichen höchstens um 25 % oder höchstens um 15 % oder höchstens um 5 %, bezogen auf einen Lichtstrom der Leuchtdiode bei 300 K.

Gemäß zumindest einer Ausführungsform der Leuchtdiode wirkt der Streukörper kurz nach dem Einschalten, zum Beispiel mindestens bis zu 1 min oder mindestens bis zu 5 min nach dem Einschalten bei Raumtemperatur, streuend. Mit anderen Worten erscheint einem Betrachter der Streukörper dann als trüb, so dass insbesondere unter dem Streukörper befindliche Strukturen, zum Beispiel einer Stromaufweitungsstruktur des Halbleiterchips, verschwommen erscheinen können.

Gemäß zumindest einer Ausführungsform der Leuchtdiode ist der Streukörper, insbesondere im bestimmungsgemäßen Gebrauch der Leuchtdiode, klarsichtig und/oder transparent. Einem Betrachter erscheint der Streukörper dann nicht als trüb.

Gemäß zumindest einer Ausführungsform der Leuchtdiode wirkt der Streukörper längere Zeit nach dem Einschalten, zum Beispiel nach 10 min oder nach 30 min oder nach dem Einstellen einer stationären Arbeitstemperatur, nicht mehr streuend. Mit anderen Worten erscheint einem Betrachter der Streukörper dann als klarsichtig.

Nachfolgend wird eine hier beschriebene Leuchtdiode unter Bezugnahme auf die Zeichnung anhand von Ausführungsbeispielen näher erläutert. Gleiche Bezugszeichen geben dabei gleiche Elemente in den einzelnen Figuren an. Es sind dabei jedoch keine maßstäblichen Bezüge dargestellt, vielmehr können einzelne Elemente zum besseren Verständnis übertrieben groß dargestellt sein.

Es zeigen:

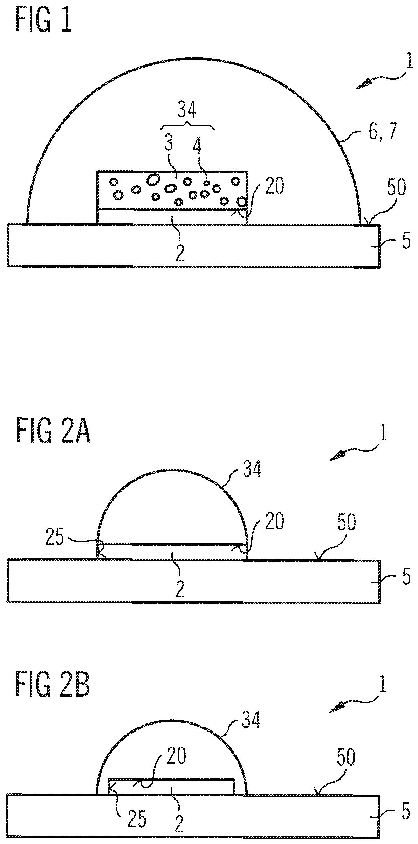

- Figuren 1 bis 4: schematische Schnittdarstellungen von Ausführungsbeispielen von hier beschriebenen Leuchtdioden mit hier beschriebenen Streukörpern.

In Figur 1 ist ein Ausführungsbeispiel der Leuchtdiode 1 dargestellt. Auf einem Träger 5 ist ein optoelektronischer Halbleiterchip 2 angebracht. An einer dem Träger 5 abgewandten Strahlungshauptfläche 20 des Halbleiterchips 2 befindet sich ein Streukörper 34. Der Streukörper 34 weist ein Matrixmaterial 3 auf, das klarsichtig und transparent für eine von dem Halbleiterchip 2 zu emittierende Strahlung ist und in das Streupartikel 4 eingebettet sind. Der Streukörper 34 ist plättchenartig geformt und beispielsweise auf die Strahlungshauptfläche 20 aufgeklebt oder unmittelbar aufgedruckt.

Das Matrixmaterial 3 beinhaltet ein phenylisiertes Silikon. Ein Brechungsindex des Matrixmaterials 3 bei Raumtemperatur beträgt zum Beispiel circa 1,49. Die Streupartikel 4 sind beispielsweise Glaskugeln mit einem mittleren Durchmesser von circa 0,5 µm und einem Brechungsindex von 1,46 bei Raumtemperatur. Ein Gewichtsanteil der Streupartikel 4 an den Streukörper 34 liegt bei circa 30 %.

Der Halbleiterchip 2, der insbesondere auf InGaAlP basiert, weist eine stationäre Arbeitstemperatur im Dauerbetrieb zum Beispiel bei 100° C auf. Gegenüber Raumtemperatur von circa 25° C bedeutet dies einen Temperaturunterschied von 75° C. Eine Brechungsindexänderung des Silikons beträgt im relevanten Temperaturbereich circa -4 x 10⁻⁴ K⁻¹. Ein Brechungsindex des Silikons nimmt also mit steigender Temperatur ab. Eine Brechungsindexänderung der Streupartikel 3 liegt bei ungefähr 0,1 x 10⁻⁵ K⁻¹ bis 1 x 10⁻⁵ K⁻¹ und ist, im Vergleich zur Brechungsindexänderung des Matrixmaterials 3, klein und kann als näherungsweise konstant angesehen werden.

Aufgrund des Brechungsindexunterschieds zwischen dem Matrixmaterial 3 und den Streupartikeln 4 von circa 0,03 bei Raumtemperatur wirkt der Streukörper 34 bei Raumtemperatur streuend. Dies führt zu einer Rückstreuung von Licht aus dem Halbleiterchip 2. Das rückgestreute Licht wird beispielsweise an dem Träger 5 oder in dem Halbleiterchip 2 absorbiert. Bei Raumtemperatur ist eine Auskoppeleffizienz von in dem Halbleiterchip 2 erzeugter Strahlung aus der gesamten Leuchtdiode 1 heraus also gezielt reduziert.

Hin zu der stationären Arbeitstemperatur nähert sich der Brechungsindex des Matrixmaterials 3 an dem Brechungsindex der Streupartikel 4 an und beide Brechungsindices betragen dann circa 1,46. Hierdurch wirkt der Streukörper 34, bei der stationären Arbeitstemperatur von circa 100° C, nicht mehr oder näherungsweise nicht mehr streuend und eine Auskoppeleffizienz ist bei dieser Temperatur erhöht. Durch den temperaturabhängigen Verlauf der Auskoppeleffizienz aufgrund der Brechungsindexänderung des Matrixmaterials 3 relativ zu den Streupartikeln 4 ist ein gegenüber Temperaturänderungen vergleichsweise unempfindlicher, stabiler Lichtstrom erzielbar.

Gemäß Figur 1 sind die Streupartikel 4 in etwa sphärisch. Alternativ oder zusätzlich hierzu können Streupartikel 4 kantige Formen, beispielsweise quaderartig oder würfelartig oder pyramidenartig, aufweisen, wie auch in allen anderen Ausführungsbeispielen. Nicht sphärische Streupartikel 4 weisen einen größeren Streuquerschnitt auf als kugelartige Streupartikel 4 mit gleichem mittlerem Durchmesser. Auch über den Durchmesser der Streupartikel 4 lässt sich der Streuquerschnitt anpassen. So kann der mittlere Durchmesser der Streupartikel 4 im Bereich der Wellenlänge der vom Halbleiterchip 2 emittierten Strahlung liegen, also zum Beispiel zwischen einschließlich 400 nm und 700 nm.

Im Vergleich zu herkömmlichen Streukörpern weisen die Streupartikel 4 gegenüber dem Matrixmaterial 3 bei Raumtemperatur einen kleinen Brechungsindexunterschied auf. Bei herkömmlichen Streukörpern sind die Streupartikel insbesondere mit einem Aluminiumoxid, Zirkoniumoxid oder Titanoxid gebildet und ein Brechungsindexunterschied zwischen einem Matrixmaterial und derartigen Partikeln ist im Regelfall größer als 0,3.

Optional ist der plättchenartige Streukörper 34 von einem weiteren Vergusskörper 6 umgeben. Der Vergusskörper 6 ist bevorzugt linsenartig, beispielsweise in Form einer Sammellinse, ausgeformt. Weiterhin optional kann dem Vergusskörper 6 ein Konversionsmittel 7 zur teilweisen Wellenlängenänderung von im Halbleiterchip 2 erzeugter Strahlung beigegeben sein.

In den folgenden Figuren sind die Streupartikel 4 sowie das Matrixmaterial 3 nicht gezeichnet, sondern nur vereinfacht der Streukörper 34 als Ganzes.

In Figur 2A und Figur 2B sind weitere Ausführungsbeispiele der Leuchtdiode 1 dargestellt. Gemäß Figur 2A bedeckt der Streukörper 34 ausschließlich die Strahlungshauptfläche 20 des Halbleiterchips 2. Der Streukörper 34 steht also nicht in Kontakt zu einer Trägeroberseite 50 des Trägers 5, wobei der Halbleiterchip 2 an der Trägeroberseite 50 angebracht ist.

Gemäß Figur 2B weist der Streukörper 34 in laterale Richtung im Wesentlichen gleiche Abmessungen auf wie der Halbleiterchip 2. Im Wesentlichen kann hierbei bedeuten, dass in lateraler Richtung eine Abmessung des Streukörpers 34 eine Abmessung des Halbleiterchips 2 entlang derselben Richtung höchstens um 30 %, insbesondere höchstens um 20 % oder höchstens um 15 % übersteigt. Gemäß Figur 2B bedeckt der Streukörper 34, der eine lateral größere Ausdehnung aufweist als der Halbleiterchip 2, Flanken 25 des Halbleiterchips 2, wobei die Flanken 25 laterale Begrenzungsflächen des Halbleiterchips 2 bilden.

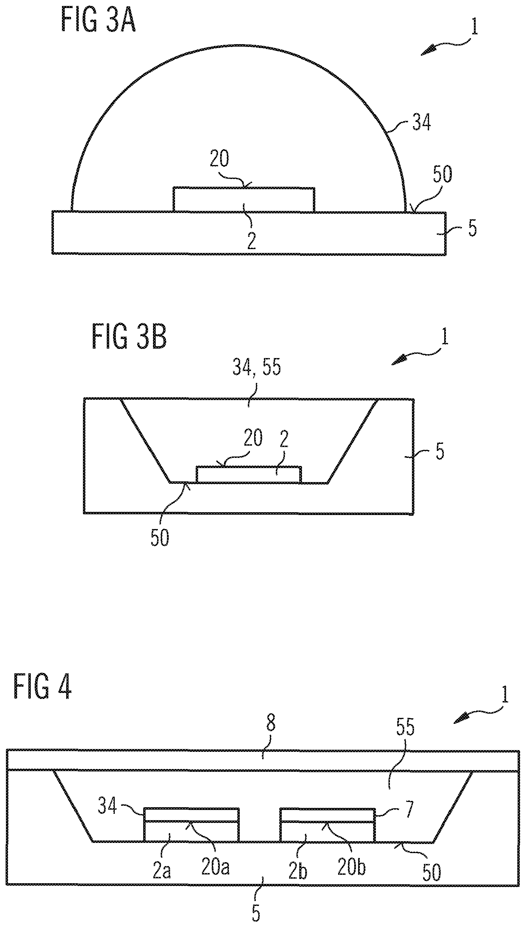

Bei den Ausführungsbeispielen gemäß den Figuren 3A und 3B ist der Streukörper 34 als Volumenverguss gestaltet. In Figur 3A ist der Streukörper 34 sphärisch oder linsenartig ausgebildet, wobei eine laterale Ausdehnung des Streukörpers 34 eine laterale Ausdehnung des Halbleiterchips 2 beispielsweise um mehr als einen Faktor 1,5 oder um mehr als einen Faktor 2 übersteigt. Eine Höhe des Streukörpers 34, in eine Richtung senkrecht zu der Trägeroberseite 50, übersteigt zum Beispiel eine mittlere Kantenlänge des Halbleiterchips 2.

Beim Ausführungsbeispiel gemäß Figur 3B weist der Träger 5 eine Ausnehmung 55 auf, in der der Halbleiterchip 2 angebracht ist. Die Ausnehmung 55 ist mit dem Streukörper 34 ausgefüllt.

Ein weiteres Ausführungsbeispiel ist in Figur 4 illustriert. Gemäß Figur 4 weist die Leuchtdiode 1 mehrere Halbleiterchips 2a, 2b auf. Zum Beispiel basiert der Halbleiterchip 2a auf InAlGaP und emittiert Strahlung im gelben oder im roten Spektralbereich. Der Halbleiterchip 2b basiert insbesondere auf AlInGaN und emittiert Strahlung im blauen Spektralbereich. Beide Halbleiterchips 2a, 2b sind auf der Trägeroberseite 50 in der optionalen Ausnehmung 55 des Trägers 5 angebracht.

Dem Halbleiterchip 2a ist der plättchenartige Streukörper 34 an der Strahlungshauptfläche 20a nachgeordnet. Der Halbleiterchip 2b ist frei von einem Streukörper. Optional ist an der Strahlungshauptfläche 20b des Halbleiterchips 2b ein Konversionsmittel 7, beispielsweise ebenfalls schichtartig ausgebildet wie der Strahlkörper 34, angebracht. Die Leuchtdiode 1 gemäß Figur 4 kann im Betrieb weißes Licht emittieren, wobei sich zum Beispiel grünlich-weißes Licht des Halbleiterchips 2b mit rotem Licht des Halbleiterchips 2a mischt. Eine Temperaturabhängigkeit des Lichtstromes des Halbleiterchips 2a ist durch den Streukörper 34 ausgleichbar, so dass die Leuchtdiode 1 auch unmittelbar nach dem Einschalten und vor Erreichen der stationären Arbeitstemperatur bereits die Strahlung der gewünschten Farbtemperatur emittiert.

Optional ist den Halbleiterchips 2a, 2b eine Abdeckplatte 8 nachgeordnet. Die Abdeckplatte 8 beinhaltet zum Beispiel ein weiteres Streumittel, über das eine Mischung der von den Halbleiterchips 2a, 2b emittierten Strahlung verbesserbar ist.

Die Erfindung ist ausschließlich durch die beigefügten Patentansprüche definiert.

## Patentansprüche

1. Leuchtdiode (1) mit
- einem oder mehreren optoelektronischen Halbleiterchips (2), und
- mindestens einem Streukörper (34), der ein strahlungsdurchlässiges Matrixmaterial (3) und darin eingebettete Streupartikel (4) aus einem Partikelmaterial aufweist und der wenigstens einem der Halbleiterchips (2) nachgeordnet ist,
wobei sich bei einer Temperaturänderung ein Brechungsindexunterschied zwischen dem Matrixmaterial (3) und dem Partikelmaterial verändert, und
der Brechungsindexunterschied zwischen dem Matrixmaterial (3) und dem Partikelmaterial bei einer Temperatur von 300 K höchsten 0,15 beträgt,
**dadurch gekennzeichnet, dass**
- in einem Temperaturbereich von einschließlich 300 K bis 375 K der Brechungsindexunterschied zwischen dem Matrixmaterial (3) und dem Partikelmaterial mit steigender Temperatur abnimmt,
- bei mindestens einer Temperatur, in einem Temperaturbereich von einschließlich 375 K bis 450 K, ein mittlerer Streuquerschnitt der Streupartikel (4) für im Betrieb in dem mindestens einen Halbleiterchip (2) erzeugte Strahlung höchstens 25 % des mittleren Streuquerschnitts der Streupartikel (4) bei einer Temperatur von 300 K beträgt,
- das Matrixmaterial (3) ein phenylisiertes Silikon beinhaltet,
- das Partikelmaterial Kalziumfluorid, Bariumfluorid, Lithiumfluorid oder Magnesiumfluorid ist, und
- ein mittlerer Durchmesser der Streupartikel (4) bei mindestens 1,5 µm und bei höchstens 5 µm liegt.

2. Leuchtdiode (1) nach dem vorhergehenden Anspruch,
bei dem das Partikelmaterial bei einer Temperatur von 300 K einen kleineren Brechungsindex aufweist als das Matrixmaterial.

3. Leuchtdiode (1) nach einem der vorhergehenden Ansprüche,
bei dem, in einem Temperaturbereich von einschließlich 300 K bis 450 K, ein Brechungsindex des Matrixmaterials (3) mit steigender Temperatur abnimmt.

4. Leuchtdiode (1) nach einem der vorhergehenden Ansprüche,
bei dem, in einem Temperaturbereich von einschließlich 300 K bis 450 K, der Brechungsindex des Partikelmaterials (4) mit steigender Temperatur zunimmt.

5. Leuchtdiode (1) nach einem der vorhergehenden Ansprüche,
bei dem der Brechungsindexunterschied zwischen dem Matrixmaterial (3) und dem Partikelmaterial bei einer Temperatur von 300 K mindestens 0,02 und/oder bei einer Temperatur von 400 K höchstens 0,01 beträgt.

6. Leuchtdiode (1) nach einem der vorhergehenden Ansprüche,
bei dem das Partikelmaterial in einem Temperaturbereich von einschließlich 300 K bis 450 K transparent und klarsichtig ist.

7. Leuchtdiode (1) nach einem der vorhergehenden Ansprüche,
bei dem ein Gewichtsanteil der Streupartikel (4) an dem Streukörper (34) zwischen einschließlich 10 % und 50 % beträgt.

## Claims

1. Light emitting diode (1) with
- one or more optoelectronic semiconductor chips (2), and
- at least one scattering body (34) having a radiation permeable matrix material (3) and scattering particles (4) of a particle material embedded therein, and being arranged downstream of at least one of the semiconductor chips (2),
wherein a refractive index difference between the matrix material (3) and the particle material changes together with a temperature change, and
the refractive index difference between the matrix material (3) and the particle material at a temperature of 300 K is at most 0.15,
**characterized in that**
- in a temperature range of 300 K to 375 K inclusively, the refractive index difference between the matrix material (3) and the particle material decreases with rising temperature,
- at at least a temperature in a temperature range 375 K to 450 K inclusively, an average scattering cross section of the scattering particles (4) for radiation generated under operation in the at least one semiconductor chip (2) is at most 25 % of the average scattering cross section of the scattering particles (4) at a temperature of 300 K,
- the matrix material (3) contains a phenilyzed silicone,
- the particle material is calcium fluoride, barium fluoride, lithium fluoride or magnesium fluoride, and
- an average diameter of the scattering particles (4) is at least 1.5 µm and at most 5 µm.

2. Light emitting diode (1) according to the preceding claim,
wherein the particle material at a temperature of 300 K has a smaller refractive index than the matrix material.

3. Light emitting diode (1) according to one of the preceding claims,
wherein, in a temperature range of 300 K to 450 K inclusively, a refractive index of the matrix material (3) decreases with rising temperature.

4. Light emitting diode (1) according to one of the preceding claims,
wherein, in a temperature range of 300 K to 450 K inclusively, the refractive index of the particle material (4) increases with rising temperature.

5. Light emitting diode (1) according to one of the preceding claims,
wherein the refractive index difference between the matrix material (3) and the particle material at a temperature of 300 K is at least 0.02 and/or at a temperature of 400 K is at most 0.01.

6. Light emitting diode (1) according to one of the preceding claims,
wherein the particle material in in a temperature range of 300 K to 450 K inclusively is transparent and clear-sighted.

7. Light emitting diode (1) according to one of the preceding claims,
wherein a part by weight of the scattering particles (4) at the scattering body (34) is between 10 % and 50 % inclusively.

## Revendications

1. Diode électroluminescente (1) comportant
- une ou plusieurs puces semi-conductrices optoélectroniques (2), et
- au moins un corps diffusant (34), comportant un matériau de matrice perméable aux rayonnements (3) et des particules diffusantes (4) d'un matériau particulaire noyées dans celui-ci et étant arrangé en aval d'au moins l'un des puces semi-conductrices (2),
une différence d'indice de réfraction entre le matériau de matrice (3) et le matériau particulaire se modifiant suite à un changement de température, et
la différence d'indice de réfraction entre le matériau de matrice (3) et le matériau particulaire s'élevant au plus à 0,15 à une température de 300 K, et **caractérisée en ce que**
- compris dans une plage de températures allant de 300 K à 375 K, l'indice de réfraction entre le matériau de matrice (3) et le matériau particulaire diminue avec l'augmentation de la température,
- à au moins une température, comprise dans une plage de températures allant de 375 K à 450 K, une section de diffusion moyenne des particules de diffusion (4) pour le rayonnement généré en fonctionnement dans une puce à semi-conducteur (2) s'élève au plus à 25% de la section efficace de diffusion moyenne des particules diffusantes (4) à une température de 300 K,
- le matériau de matrice (3) comprend un silicone phénylé,
- le matériau particulaire est fluoride de calcium, fluoride de Barium, fluoride de lithium ou fluoride de magnésium, et
- une section de diffusion moyenne des particules de diffusion (4) est au moins 1,5 µm et au plus 5 µm.

2. Diode électroluminescente (1) selon la revendication précédente,
dans laquelle le matériau particulaire à une température de 300 K a un indice de réfraction inférieur à celui du matériau de matrice.

3. Diode électroluminescente (1) selon l'une quelconque des revendications précédentes,
dans laquelle comprise dans une plage de températures allant de 300 K à 450 K, un indice de réfraction du matériau de matrice (3) diminue avec l'augmentation de la température.

4. Diode électroluminescente (1) selon l'une quelconque des revendications précédentes,
dans laquelle comprise dans une plage de températures allant de 300 K à 450 K, le matériau particulaire (4) augmente avec l'augmentation de la température.

5. Diode électroluminescente (1) selon l'une quelconque des revendications précédentes,
la différence d'indice de réfraction entre le matériau de matrice (3) et le matériau particulaire à une température de 300 K s'élève au moins à 0,02 et / ou à une température de 400 K au plus à 0,01.

6. Diode électroluminescente (1) selon l'une quelconque des revendications précédentes,
dans laquelle le matériau particulaire compris dans une plage de températures de 300 K à 450 K est transparent et limpide.

7. Diode électroluminescente (1) selon l'une quelconque des revendications précédentes,
dans laquelle une proportion pondérale des particules diffusantes (4) au corps diffusant (34) est comprise entre 10% et 50%.
